# EUROPÄISCHE PATENTSCHRIFT

(11) **EP 3 380 433 B1**
(45) Veröffentlichungstag und Bekanntmachung des Hinweises auf die Patenterteilung: **05.08.2020**
(21) Anmeldenummer: 16798750.2
(22) Anmeldetag: 22.11.2016
(51) Int. Cl.: B81C 1/00

(54) **VERFAHREN ZUM VERPACKEN MINDESTENS EINES HALBLEITERBAUTEILS UND HALBLEITERVORRICHTUNG**
METHOD FOR PACKAGING AT LEAST ONE SEMICONDUCTOR COMPONENT AND SEMICONDUCTOR DEVICE
PROCÉDÉ DE MISE SOUS BOÎTIER D'AU MOINS UN COMPOSANT SEMI-CONDUCTEUR ET COMPOSANT SEMI-CONDUCTEUR

(30) Priorität: 26.11.2015 DE 102015223399
(43) Veröffentlichungstag der Anmeldung: 03.10.2018
(73) Patentinhaber: Robert Bosch GmbH, 70442 Stuttgart (DE)
(72) Erfinder: KRAUSS, Andreas, 72072 Tübingen (DE); MINGIRULLI, Nicola, 70197 Stuttgart (DE); BONASEWICZ, Robert, 70563 Stuttgart (DE)
(86) Internationale Anmeldenummer: PCT/EP2016/078410
(87) Internationale Veröffentlichungsnummer: WO 2017/089338

(56) Entgegenhaltungen:
- WO-A1-2015/094116
- US-A1- 2010 307 786

## Beschreibung

Die Erfindung betrifft ein Verfahren zum Verpacken mindestens eines Halbleiterbauteils. Des Weiteren betrifft die Erfindung eine Halbleitervorrichtung.

### Stand der Technik

In der DE 10 2010 064 108 A1 sind ein Verfahren zur Verpackung eines Sensorchips und ein dermaßen hergestelltes Bauteil beschrieben. Bei einer Ausführungsform des Verfahrens zur Verpackung eines Sensorchips wird der Sensorchip auf einer Montagefläche eines Trägers montiert. Danach wird der Träger im Bereich neben der Montagefläche des Sensorchips mit einer Metallisierung versehen. Anschließend wird eine sich von der Metallisierung bis zu einem sensitiven Bereich des Sensorchips erstreckende (Laserstrukturierbare) Polymerschicht gebildet, welche einen Teilabschnitt eines späteren Medienzugangs vorgibt. Dann wird der Sensorchip zumindest teilweise in eine Moldmasse eingebettet. Schließlich wird ein Restabschnitt des Medienzugangs durch Laser-Strukturierung der Moldmasse und der Polymerschicht erzeugt, wobei die Metallisierung als Stoppschicht dient. Die DE 10 2010 064 108 A1 offenbart entsprechend auch eine Halbleitervorrichtung umfassend ein Halbleiterbauteil, welches teilweise von einem optisch abtragbaren Verpackungsmaterial umgeben ist, wobei mindestens eine Teiloberfläche des Halbleiterbauteils freigelegt ist. Im optisch abtragbaren Verpackungsmaterial befindet sich ein Graben, der eine an einer Außengrenzfläche des Verpackungsmaterials angrenzende erste Grabenwandfläche aus dem Verpackungsmaterial mit Lichtabtragspuren aufweist.

### Offenbarung der Erfindung

Die Erfindung schafft ein Verfahren zum Verpacken mindestens eines Halbleiterbauteils mit den Merkmalen des Anspruchs 1 und eine Halbleitervorrichtung mit den Merkmalen des Anspruchs 9.

### Vorteile der Erfindung

Die Erfindung schafft ein sehr kostengünstig und einfach ausführbares Verfahren zum Verpacken mindestens eines Halbleiterbauteils, welches besonders für Sensorbauteile (Sensorchips), die auch nach ihrer Verpackung mindestens einen (lokal begrenzten) Medienzugang und/oder mindestens einen (lokal begrenzten) Messgang benötigen, geeignet ist. Es wird darauf hingewiesen, dass die vorliegende Erfindung (im Gegensatz zum Stand der Technik) keine Metallisierung als Stoppschicht während einer Laser-Strukturierung benötigt. (Stattdessen erfüllt das chemisch oder physikalisch auflösbare Opfermaterial die Funktion einer "Laser-Stopp- bzw. Laser-Absorberschicht".) Damit muss zum Ausführen des erfindungsgemäßen Verfahrens zum Verpacken mindestens eines Halbleiterbauteils keine Metallisierung gebildet werden. Ebenso muss keine Metallisierung entfernt oder als an der fertigen Halbleitervorrichtung überflüssige Komponente in Kauf genommen werden. Damit reduziert die vorliegende Erfindung die Herstellungskosten einer mittels des erfindungsgemäßen Verfahrens hergestellten Halbleitervorrichtung. Außerdem kann die erfindungsgemäße Halbleitervorrichtung aufgrund ihrer vergleichsweise einfachen Herstellbarkeit unter verlässlicher Einhaltung eines gewünschten Standards (mit einer guten Qualität und einer geringen Fehlerhäufigkeit) gebildet werden.

Die vorliegende Erfindung schafft Moldgehäuse für die Verpackung von Halbleitern und Mikrosystemtechnikkomponenten. Sie eignet sich auch für die Plastic Molded Package-Technologie von MEMS-Sensoren mit einem MEMS-Sensor-Package. Es wird darauf hingewiesen, dass die vorliegende Erfindung auch für ein Verpacken von Halbleiterbauteilen auf Waferebene nutzbar ist. Die vorliegende Erfindung trägt auch zum Schutz von Halbleiterbauteilen während einer Halbleiterprozessierung bei, da das mindestens eine verpackte Halbleiterbauteil (nahezu) risikofrei weiterverarbeitet werden kann.

Die erfindungsgemäßen Verfahren und Halbleitervorrichtungen eignen sich für Sensoren mit mindestens einem Medienzugang und/oder mit mindestens einem Messgang. Derartige Sensoren können beispielsweise Inertialsensoren, Drucksensoren, Beschleunigungssensoren, Strömungssensoren, Feuchtigkeitssensoren und/oder chemische Nachweissensoren (Flüssigkeitssensoren und/oder Gassensoren) sein. Es wird ausdrücklich darauf hingewiesen, dass die Verwendbarkeit der erfindungsgemäßen Verfahren und Halbleitervorrichtungen nicht auf einen bestimmten Typ eines chemischen oder physikalischen Sensors beschränkt ist.

In einer vorteilhaften Ausführungsform des Verfahrens wird der mindestens eine Graben jeweils mittels des Lichtstrahls mit mindestens einer an einer Außengrenzfläche des Verpackungsmaterials angrenzenden ersten Grabenwandfläche aus dem Verpackungsmaterial mit Lichtabtragspuren und mittels des chemischen oder physikalischen Abtragverfahrens mit mindestens einer zweiten Grabenwandfläche, welche im Vergleich mit der mindestens einen ersten Grabenwandfläche des gleichen Grabens näher an der zugeordneten Teiloberfläche liegt, zumindest teilweise aus dem Verpackungsmaterial besteht und mit Füllstoffabtragspuren, Ätzresten und/oder Abformeffekten gebildet ist, ausgebildet, wobei der jeweilige mindestens eine Graben zwischen der mindestens einen ersten Grabenwandfläche und der mindestens einen zweiten Grabenwandfläche metallisierungs-frei ausgebildet wird.

Beispielsweise kann zum Abdecken der mindestens einen Teiloberfläche eine Opfermaterialschicht aus dem Opfermaterial auf dem mindestens einen Halbleiterbauteil abgeschieden und so strukturiert werden, dass die mindestens eine Teiloberfläche mit dem Opfermaterial abgedeckt bleibt, wobei mindestens eine konkave Außenfläche und/oder mindestens eine konvexen Außenfläche des die mindestens eine Teiloberfläche abdeckenden Opfermaterials gebildet wird. Dies ist daran erkennbar, dass die mindestens eine zumindest teilweise aus dem Verpackungsmaterial gebildete zweite Grabenwandfläche mit einer konvexen Wölbung und/oder einer konkaven Wölbung ausgebildet wird.

Ebenso kann zum Strukturieren der Opfermaterialschicht eine photo-strukturierbare Schicht auf der Opfermaterialschicht strukturiert werden, wobei mindestens ein Restbereich der photo-strukturierbaren Schicht teilweise beim Bilden des mindestens einen Grabens mittels des Lichtstrahls entfernt wird. Dies bleibt erkennbar, da Materialreste der photo-strukturierbaren Schicht zwischen der mindestens einen ersten Grabenwandfläche und der mindestens einen zweiten Grabenwandfläche verbleiben oder eine Abformung der Materialreste der photo-strukturierbaren Schicht zwischen der mindestens einen ersten Grabenwandfläche und der mindestens einen zweiten Grabenwandfläche ausgeformt wird.

In einer vorteilhaften Anwendung des Verfahrens wird mindestens ein Sensorbauteil als das mindestens eine Halbleiterbauteil mit dem Verpackungsmaterial verpackt, wobei mindestens ein Medienzugang und/oder mindestens ein Messgang als der mindestens eine Graben gebildet werden. Das Verfahren kann somit zum kostengünstigen Verpacken von Sensoren/Sensorelementen genutzt werden. Es wird jedoch darauf hingewiesen, dass eine Ausführbarkeit des Verfahrens nicht auf eine bestimmte Ausbildung des mindestens einen Sensorbauteils, bzw. auf eine spezielle Nutzung des mindestens einen Grabens, beschränkt ist.

Beispielsweise wird mindestens ein sensitives Material zum Nachweisen mindestens eines Stoffes auf der mindestens einen freigelegten Teiloberfläche abgeschieden. Die hier beschriebene Ausführungsform des Verfahrens eignet sich somit besonders gut zur Verpackung von Nachweissensoren, wie beispielsweise Gassensoren.

Insbesondere können mindestens zwei Gräben pro Halbleiterbauteil gebildet werden, wobei unterschiedliche sensitive Materialien in den mindestens zwei Gräben pro Halbleiterbauteil abgeschieden werden. Damit kann ein mittels der hier beschriebenen Ausführungsform des Verfahrens verpacktes einzelnes Halbleiterbauteil/Sensorbauteil zum Nachweisen mehrerer Stoffe eingesetzt werden. Mittels der auf diese Weise gewährleisteten Multifunktionalität des einzelnen Halbleiterbauteils/Sensorbauteils können zusätzliche Komponenten zum Stoffnachweis eingespart werden. Außerdem trägt die hier beschriebene Ausführungsform des Verfahrens zur Reduzierung von Herstellungskosten, eines Bauraumbedarfs und einer Anbringfläche für ein Nachweissystem zum Nachweisen mehrerer Stoffe bei.

In einer weiteren vorteilhaften Ausführungsform des Verfahrens wird der mindestens eine Graben zumindest durch das Verpackungsmaterial mittels des Lichtstrahls mindestens in Form einer Umrahmung eines Pfropfens gebildet, wobei der Pfropfen beim Entfernen des zuvor freigelegten Opfermaterials zumindest teilweise mittels des chemischen oder physikalischen Abtragverfahrens mitentfernt wird. Mittels dieser Ausführungsform des Verfahrens können somit relativ große Kavernen an dem mindestens einen verpackten Halbleiterbauteil ausgebildet werden, ohne dass dazu der gesamte Verpackungsmaterialabtrag mittels des Lichtstrahls zu bewirken ist.

Außerdem kann der mindestens eine Graben zumindest durch das Verpackungsmaterial mittels des Laserstrahls in Form einer Teilumrahmung einer späteren Teilabschirmung der mindestens einen Teiloberfläche gebildet werden, wobei das zwischen der Teilabschirmung und der jeweiligen Teiloberfläche liegende Opfermaterial zumindest teilweise mittels des chemischen oder physikalischen Abtragverfahrens entfernt wird. Die auf diese Weise gebildete Teilabschirmung kann zum Schutz des damit ausgestatteten Halbleiterbauteils vor Verschmutzungen und/oder einer Krafteinwirkung darauf beitragen.

Die in den vorausgehenden Absätzen beschriebenen Vorteile sind auch bei einer entsprechenden Halbleitervorrichtung realisiert. Außerdem ist die Halbleitervorrichtung gemäß der oben beschriebenen Ausführungsformen des Herstellungsverfahrens weiterbildbar.

### Kurze Beschreibung der Zeichnungen

Weitere Merkmale und Vorteile der vorliegenden Erfindung werden nachfolgend anhand der Figuren erläutert. Es zeigen:
- Fig. la bis 1h: schematische Querschnitte zum Erläutern einer ersten Ausführungsform des Verfahrens zum Verpacken mindestens eines Halbleiterbauteils;
- Fig. 2a und 2b: schematische Querschnitte zum Erläutern einer zweiten Ausführungsform des Verfahrens zum Verpacken mindestens eines Halbleiterbauteils;
- Fig. 3: einen schematischen Querschnitt zum Erläutern einer dritten Ausführungsform des Verfahrens zum Verpacken mindestens eines Halbleiterbauteils;
- Fig. 4: eine schematische Darstellung einer ersten Ausführungsform der Halbleitervorrichtung; und
- Fig. 5: eine schematische Darstellung einer zweiten Ausführungsform der Halbleitervorrichtung.

### Ausführungsformen der Erfindung

Fig. la bis 1h zeigen schematische Querschnitte zum Erläutern einer ersten Ausführungsform des Verfahrens zum Verpacken mindestens eines Halbleiterbauteils.

In Fig. la ist beispielhaft ein Halbleiterwafer 10 aus mindestens einem Halbleitermaterial, wie beispielsweise Silizium, dargestellt, in welchem eine Vielzahl von (funktionalisierten) Halbleiterbauteilen (Halbleiterchips) 12 ausgebildet sind/werden. Auf diese Weise soll illustriert werden, dass die im Weiteren beschriebenen Verfahrensschritte auch auf Waferebene durchführbar sind. Jedoch können die im Weiteren beschriebenen Verfahrensschritte (fast alle) auch nur mit einem einzigen Halbleiterbauteil 12 (anstelle der Vielzahl von Halbleiterbauteilen 12) ausgeführt werden.

Zusätzlich zu dem mindestens einen Halbleitermaterial kann der Halbleiterwafer 10/das mindestens eine Halbleiterbauteil 12 auch mindestens ein isolierendes Material und/oder mindestens ein Metall (beispielsweise in Form einer Leiterbahn) aufweisen. Mittels des mindestens einen Metalls kann insbesondere bei einem späteren (starken) Beleuchten des Halbleiterwafers 10/des mindestens einen Halbleiterbauteils 12 Licht reflektiert werden. Auf diese Weise kann eine Schädigung/ein Ausbleichen von mittels des mindestens einen Metalls abgedeckten Materialien verhindert werden. Das mindestens eine Metall kann z.B. Aluminium, AlSiCu und/oder mindestens ein Edelmetall (wie Gold oder Platin) sein. Das mindestens eine isolierende Material kann z.B. Siliziumoxid, Siliziumnitrid und/oder Aluminiumoxid sein.

In dem Halbleiterwafer 10 können mehrere 10000 Halbleiterbauteile 12 ausgebildet sein. Jedes der Halbleiterbauteile 12 kann z.B. mit einer funkionalisierten Fläche von etwa 1 mm² ausgebildet sein. Der Halbleiterwafer 10 kann einen Durchmesser von etwa 200 mm haben. Die einzelnen Halbleiterbauteile 12 können durch nicht-funktionelle Bereiche voneinander getrennt sein.

Zum Ausführen des Verfahrens zum Verpacken mindestens eines Halbleiterbauteils (Halbleiterchips) 12 wird mindestens eine Teiloberfläche 14 des mindestens einen Halbleiterbauteils 12 mit zumindest einem chemisch oder physikalisch auflösbaren Opfermaterial 16 abgedeckt. Dabei wird zum Abdecken der mindestens einen Teiloberfläche 14 eine Opfermaterialschicht 16a (aus dem Opfermaterial 16) auf dem mindestens einen Halbleiterbauteil 12 abgeschieden und so strukturiert, dass die mindestens eine Teiloberfläche 14 mit dem Opfermaterial 16 abgedeckt bleibt. Die Opfermaterialschicht 16a kann z.B. eine Schichtdicke zwischen 1 µm bis 10 µm haben.

Zum Strukturieren der Opfermaterialschicht 16a wird eine photo-strukturierbare Schicht 18a (aus einem photo-strukturierbaren Material 18) auf der Opfermaterialschicht 16a abgeschieden und (später) strukturiert. Eine Schichtdicke der photo-strukturierbaren Schicht 18a kann zum Beispiel in einem Bereich zwischen 0,5 µm bis 5 µm liegen. (Die hier genannten Zahlenwerte für die Schichtdicken der Schichten 16a und 18a sind jedoch nur beispielhaft zu interpretieren. Auch bei anderen Schichtdicken der Schichten 16a und 18a kann ein Lithographieschritt zu deren Strukturierung noch erfolgreich ausgeführt werden.)

Fig. la zeigt den Halbleiterwafer 10 nach dem Abscheiden der Schichten 16a und 18a. Es wird jedoch darauf hingewiesen, dass in Varianten, die nicht Gegenstand der vorliegenden Erfindung sind, die Verwendung der photo-strukturierbaren Schicht 18a zum Strukturieren der Opfermaterialschicht 16a optional ist. Alternativ kann auch ein Opfermaterial 16 verwendet werden, welches leicht ohne die Verwendung eines Zusatzmaterials strukturierbar ist. Ebenso kann anstelle des photo-strukturierbaren Materials 18 auch ein anderes mittels eines Halbleiterverfahrens ortsaufgelöst strukturierbares Material zum Strukturieren der Opfermaterialschicht 16a eingesetzt werden.

Unter dem Opfermaterial 16 ist ein Material zu verstehen, welches chemisch (mittels eines Lösungsmittels) oder physikalisch (z.B. mittels eines Sauerstoffplasmas) auflösbar ist. Eine Verwendung eines photo-strukturierbaren Materials als das Opfermaterials 16 ist optional, jedoch wird eine Verwendung eines nicht photo-strukturierbaren/Laser-strukturierbaren Materials als das Opfermaterials 16 bevorzugt. Das photo-strukturierbare Material 18 ist beispielsweise ein photolithographischer Lack.

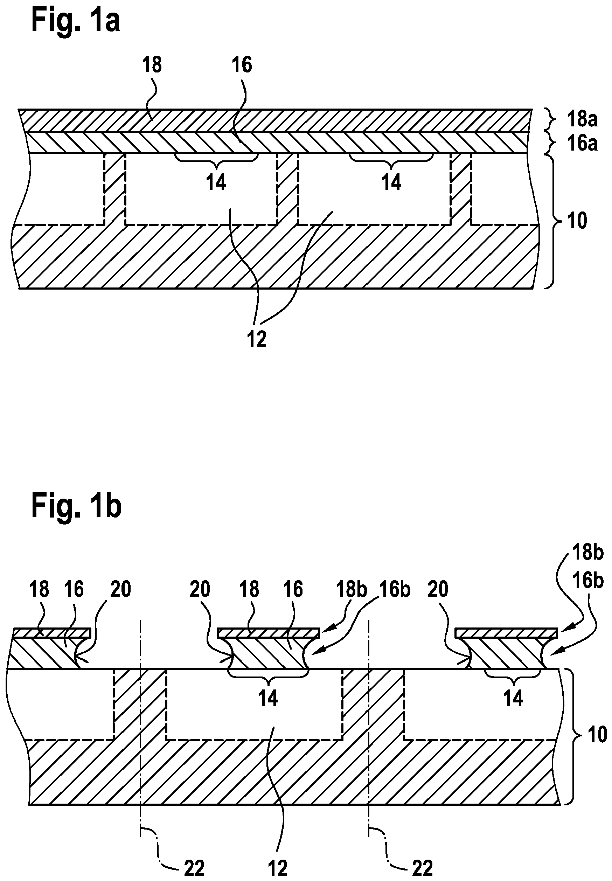

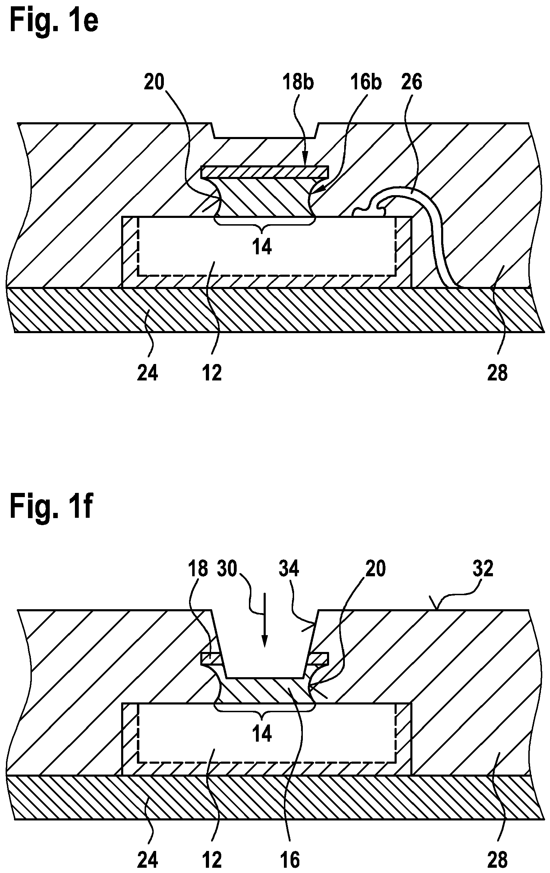

Fig. 1b zeigt den Schichtaufbau nach einem Strukturieren der photo-strukturierbaren Schicht 18a, wobei die von der photo-strukturierbaren Schicht 18a abgedeckte Opferschicht 16a mitstrukturiert wird. Die photo-strukturierbare Schicht 18a kann beispielsweise an zuvor belichteten Stellen mittels eines nasschemischen Verfahrensschritts aufgelöst werden, wodurch auch die Opfermaterialschicht 16a an den von der photo-strukturierbaren Schicht 18a freigelegten Stellen mitaufgelöst wird. Bevorzugt findet dies z.B. mittels eines alkalischen Entwicklers statt.

Die Strukturierung der Schichten 16a und 18a erfolgt so, dass die mindestens eine Teiloberfläche 14 abdeckende Restbereiche 16b und 18b (aus den Materialien 16 und 18) verbleiben. Außerdem wird mindestens eine gewölbte Außenfläche 20 des die mindestens eine Teiloberfläche 14 abdeckenden Opfermaterials 16/Restbereichs 16b gebildet. In der Regel ist die gewölbte Außenfläche 20 des die mindestens eine Teiloberfläche 14 abdeckenden Opfermaterials 16/Restbereichs 16b eine konkave Außenfläche 20. Evtl. kann die gewölbte Außenfläche 20 auch als eine konvexe Außenfläche des die mindestens eine Teiloberfläche 14 abdeckenden Opfermaterials 16/Restbereichs 16b gebildet werden. Die mindestens eine gewölbte Außenfläche 20 des die mindestens eine Teiloberfläche 14 abdeckenden Opfermaterials 16/Restbereichs 16b entsteht, da das Opfermaterial 16 während des Strukturierens an seinen Seitenkanten angegriffen/geätzt wird. (Unter der mindestens einen gewölbten Außenfläche 20 kann eine "nach Innen gewölbte Außenfläche" verstanden werden. Sie kann sich von der zugeordneten Teiloberfläche 14 bis zu dem abdeckenden Restbereich 18b aus photo-strukturierbarem Material 18 erstrecken.)

Wie mittels der Trennlinien 22 in Fig. 1b dargestellt ist, können die Halbleiterbauteile 12 nach dem Strukturieren (zumindest) der Opfermaterialschicht 16a vereinzelt werden. Es wird jedoch darauf hingewiesen, dass die im Weiteren beschriebenen Verfahrensschritte auch auf Waferebene ausführbar sind. Das mittels der Trennlinien 22 dargestellte Vereinzeln der Halbleiterbauteile 12 des Halbleiterwafers 10 zu diesem Zeitpunkt des Verfahrens ist lediglich optional.

Die Trennlinien 22 können beispielsweise durch die nicht-funktionellen Bereiche zwischen zwei benachbarten Halbleiterbauteilen 12 des Halbleiterwafers 10 verlaufen. Das Vereinzeln der Halbleiterbauteile 12 kann beispielsweise mittels eines (nachträglich noch genutzten) Lichtstrahls erfolgen. Beispielsweise kann ein Laser zum Vereinzeln der Halbleiterbauteile 12 eingesetzt werden. (Mittels eines Lasers erzeugte Trennlinien 22 haben in der Regel eine Breite von 30 µm bis 50 µm.) Die Restbereiche 16b und 18b aus den Materialien 16 und 18 verbleiben während des Vereinzelns (zu diesem Zeitpunkt des Verfahrens) auf der mindestens einen Teiloberfläche 14. Eine Beschädigung oder Verschmutzung der mindestens einen Teiloberfläche 14, z.B. durch beim Vereinzeln freigesetzte Partikel oder durch beim Vereinzeln eingesetztes Kühlwasser, muss somit während des Vereinzelns nicht befürchtet werden.

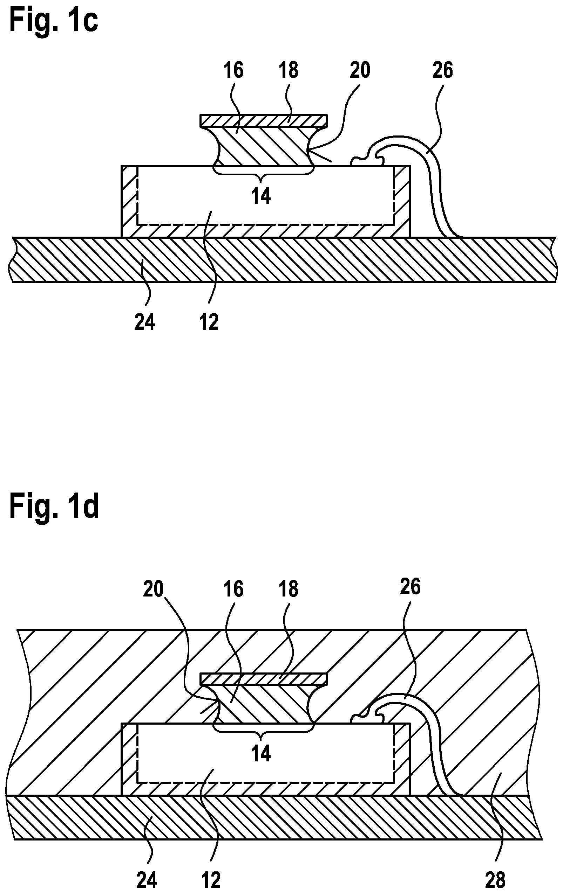

Fig. 1c zeigt eine Leiterplatte 24, auf welcher mindestens ein (vereinzeltes und evtl. rückseitig-verdünntes) Halbleiterbauteil 12 angeordnet/befestigt ist. Das Halbleiterbauteil 12 kann beispielsweise auf die Leiterplatte 24 aufgeklebt werden. Ein Transportieren des mindestens einen Halbleiterbauteils 12 kann per Pick-and-Place-Verfahren erfolgen. Die Restbereiche 16b und 18b aus den Materialien 16 und 18 verbleiben während des Transportierens des mindestens einen Halbleiterbauteils 12 und des Aufbringens des mindestens einen Halbleiterbauteils 12 auf die Leiterplatte 24. Somit ist das mindestens eine Halbleiterbauteil 12 bei allen hier beschriebenen Verfahrensschritten zumindest an der mindestens einen Teiloberfläche 14 vor Verschmutzungen oder Beschädigungen geschützt. Außerdem kann eine Vakuumansaugung für das Pick-and-Place-Verfahren an den Restbereichen 16b und 18b erfolgen.

Die Leiterplatte 24 kann als spätere Basisplatte eines Land Grid Array-Gehäuses genutzt werden. Die Leiterplatte 24 kann auch mehrere (bis zu hundert) von einzelnen Halbleiterbauteilen 12 aufnehmen. Es wird jedoch ausdrücklich darauf hingewiesen, dass die Verwendung der Leiterplatte 24 zum Ausführen der hier beschriebenen Verfahren nicht notwendig ist.

Das mindestens eine Halbleiterbauteil 12 auf der Leiterplatte 24 kann optional mittels mindestens eines Drahtbonds 26 elektrisch mit dieser verbunden werden. (Ein einzelnes Halbleiterbauteil 12 kann mehrere Drahtbonds 26, z.B. zwölf Drahtbonds 26, haben.) Auch während des optionalen Bildens des mindestens einen Drahtbonds 26 verbleiben die Restbereiche 16b und 18b aus den Materialien 16 und 18 auf der mindestens einen Teiloberfläche 14 und schützen deshalb die mindestens eine Teiloberfläche 14.

In einem weiteren Verfahrensschritt wird das mindestens eine Halbleiterbauteil 12 mit mindestens einem optisch abtragbaren Verpackungsmaterial 28 zumindest teilweise umgeben. Dabei wird auch zumindest das Opfermaterial 16 und das photo-strukturierbare Material 18 auf der mindestens einen Teiloberfläche 14 des mindestens einen Halbleiterbauteils 12 mit dem Verpackungsmaterials 28 umgeben. Das Resultat ist in Fig. 1d oder le gezeigt.

Unter dem optisch abtragbaren Verpackungsmaterial 28 kann z.B. ein (Kunststoff-basiertes) Material verstanden werden, welches aufgeschmolzen und bei einem hohen Druck um das mindestens eine Halbleiterbauteil 12 herumgegossen wird. Das optisch abtragbare Verpackungsmaterial 28 kann insbesondere ein zum Molden geeignetes Material (Moldmaterial) sein. Das Aufbringen des Verpackungsmaterials 28 kann somit mittels eines Mold-Verfahrens erfolgen. Dabei kann neben einem hohen Druck auch eine hohe Temperatur (von bis zu 250°) auftreten, die neben einer initialen Verflüssigung des Verpackungsmaterials 28 dessen nachfolgendes thermisch-initiiertes Aushärten bewirkt. Das optisch abtragbare Verpackungsmaterial 28 kann z.B. Epoxidharz (evtl. mit mindestens einem Füllstoff) sein. Bei den auftretenden hohen Temperaturen findet oft eine Nachhärtung des photo-strukturierbaren Materials 18 statt, so dass das photo-strukturierbare Material 18 außer mit einem optischen Abtragungsprozess nur noch schwer abgetragen werden kann.

Wie in Fig. 1d dargestellt ist, kann das Verpackungsmaterial 28 mit einer (nahezu) konstanten Schichtdicke, z.B. mit einer Schichtdicke von etwa 50 µm, auf der Leiterplatte 24 abgeschieden werden. Ebenso kann die Schichtdicke des Verpackungsmaterials an der mindestens einen Stelle, an welcher sie die Restbereiche 16b und 18b abdeckt, gegenüber anderen Stellen durch Verwendung einer (als Insert oder als Stempel realisierbaren) Erhöhung in der Moldform reduziert werden (siehe Fig. le). (Ein Freihalten der Restbereiche 16b und 18b beim Aufbringen des Verpackungsmaterials 28 ist in der Regel nicht möglich, aufgrund der Toleranzen zwischen einer Moldform und einem Halbleiterbauteil 12 von mindestens 10 µm oder darüber.)

Nach dem Umgeben des mindestens einen Halbleiterbauteils 12 zumindest teilweise mit dem optisch abtragbaren Verpackungsmaterial 28 wird das Opfermaterial 16 auf der mindestens einen Teiloberfläche 14 des mindestens einen Halbleiterbauteils 12 zumindest teilweise freigelegt. Dies erfolgt durch Bilden mindestens eines Grabens 30 zumindest durch das Verpackungsmaterial 28 mittels eines Lichtstrahls, wobei zumindest das Verpackungsmaterial 28 bereichsweise optisch abgetragen wird. Auch der mindestens eine Restbereich 18b aus dem photo-strukturierbaren Material 18 wird zumindest teilweise beim Bilden des mindestens einen Grabens 30 mittels des Lichtstrahls entfernt. Dies ist vorteilhaft, da das photo-strukturierbare Material 18, wie oben aufgeführt, durch Nachhärtung nur noch schwer abtragbar ist. Bevorzugt wird jedoch das Opfermaterial 16 beim Bilden des mindestens einen Grabens 30 nicht/kaum angegriffen. Zum Bilden des mindestens einen Grabens 30 kann insbesondere der gleiche Laser eingesetzt werden, welcher auch (zuvor) zum Vereinzeln von Halbleiterbauteilen 12 und/oder (danach) zum Beschriften von Halbleiterbauteilen 12/fertigen Halbleitervorrichtungen verwendet wird.

Der mindestens eine Graben 30 wird mittels des Lichtstrahls jeweils mit mindestens einer an einer Außengrenzfläche 32 des Verpackungsmaterials 28 angrenzenden ersten Grabenwandfläche 34 aus dem Verpackungsmaterial 28 mit Lichtabtragspuren/ Laserabtragspuren ausgebildet. Derartige Lichtabtragspuren/Laserabtragspuren können beispielsweise eine Farbveränderung des Verpackungsmaterials 28 (evtl. ein Ausbleichen des Verpackungsmaterials 28) und/oder ein Ab- bzw. Aufplatzen von Glaskörnern im Verpackungsmaterial 28 unmittelbar an der mindestens einen ersten Grabenwandfläche 34 sein. (Unter der jeweiligen Außengrenzfläche 32 des Verpackungsmaterials 28 ist vorzugsweise eine von dem Halbleiterbauteil 12 weg gerichtete Grenzfläche des Verpackungsmaterials 28 zu verstehen.)

Wie in Fig. 1f bildlich wiedergegeben ist, ist ein Entfernen des Opfermaterials 16 mittels des Lichtstrahls nicht notwendig. Deshalb muss für das Opfermaterial 16 auch kein optisch-abtragbares/kein Laser-strukturierbares Material gewählt werden. Auch ein vollständiges Freilegen des Opfermaterials 16 mittels des mindestens einen Grabens 30 ist nicht notwendig. Stattdessen ist es ausreichend, wenn zumindest ein Teil jedes Restbereichs 16b aus dem Opfermaterial 16 so freigelegt wird, dass eine spätere chemische oder physikalische Auflösbarkeit des Opfermaterials 16 gewährleistet ist.

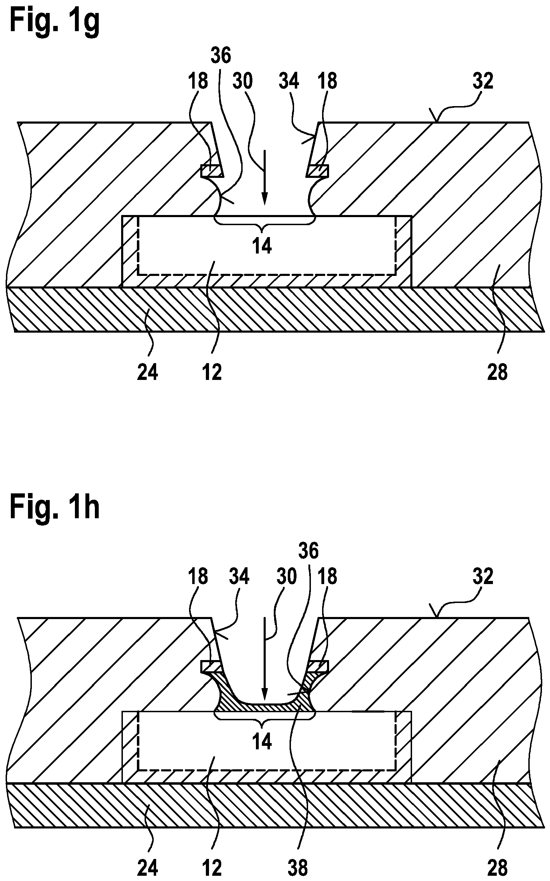

Als weiterer Verfahrensschritt wird, wie in Fig. 1g dargestellt ist, die mindestens eine Teiloberfläche 14 des mindestens einen Halbleiterbauteils 12 zumindest teilweise freigelegt. Dies geschieht durch ein zumindest teilweises Entfernen des zuvor freigelegten Opfermaterials 16 mittels eines chemischen oder physikalischen Abtragverfahrens. Dabei wird ein Abtragverfahren ausgeführt, gegen welches das Verpackungsmaterial 28 im Vergleich mit dem Opfermaterial 16 eine höhere Resistenz aufweist. Insbesondere kann das Verpackungsmaterial 28 (nahezu) beständig gegenüber dem chemischen oder physikalischen Abtragverfahren sein.

Mittels des chemischen oder physikalischen Abtragverfahrens wird mindestens eine zweite Grabenwandfläche 36 des mindestens einen (verlängerten/vertieften) Grabens 30 gebildet, welche im Vergleich mit der mindestens einen (mittels des Lichtstrahls gebildeten) ersten Grabenwandfläche 34 des gleichen Grabens 30 näher an der zugeordneten Teiloberfläche 14 liegt. Die (mittels des chemischen oder physikalischen Abtragverfahrens gebildete) mindestens eine zweite Grabenwandfläche 36 besteht zumindest teilweise aus dem Verpackungsmaterial und ist mit Füllstoffabtragspuren, Ätzresten und/oder Abformeffekten ausgebildet. Beispielsweise kann (mittels des chemischen oder physikalischen Abtragverfahrens) die mindestens eine zweite Grabenwandfläche (36) mit mindestens einer konvexen Wölbung und/oder mindestens einer konkaven Wölbung (zumindest teilweise aus dem Verpackungsmaterial 28) ausgebildet werden. (Unter der mindestens einen konvexen Wölbung kann mindestens eine Wölbung "in den zugeordneten Graben 30 hinein" verstanden werden.) Die mindestens eine konvexe Wölbung (siehe Fig. 1g) ergibt sich aufgrund der mindestens einen zuvorigen konkaven Außenfläche 20 des entfernten Opfermaterials 16. Entsprechend kann sich mindestens eine konkave Wölbung aufgrund mindestens einer zuvorigen konvexen Außenfläche des entfernten Opfermaterials 16 ergeben.

In der Regel führt das chemische oder physikalische Abtragverfahren kaum zu einer (signifikanten) Änderung an der mindestens einen (an der Außengrenzfläche 32 angrenzenden) ersten Grabenwandfläche 34. Deshalb weist der mindestens eine Graben 30 (auch nach einem vollständigen Ausführen des hier beschriebenen Verfahrens) die mindestens eine (an der Außengrenzfläche 32 angrenzende) erste Grabenwandfläche 34 aus dem Verpackungsmaterial 28 mit Lichtabtragspuren/ Laserabtragspuren und die mindestens eine zweite Grabenwandfläche 36 zumindest teilweise aus dem Verpackungsmaterial und mit Füllstoffabtragspuren, Ätzresten und/oder Abformeffekten auf.

Es wird ausdrücklich darauf hingewiesen, dass der mindestens eine Graben 30 zwischen der mindestens einen ersten Grabenwandfläche 34 und der mindestens einen zweiten Grabenwandfläche 36 metallisierungs-frei ausgebildet wird. Darunter ist zu verstehen, dass alle evtl. zwischen der mindestens einen ersten Grabenwandfläche 34 und der mindestens einen zweiten Grabenwandfläche 36 vorliegenden Innenflächen des mindestens einen Grabens 30 unabgedeckt/frei von einer Metallisierung sind.

Materialreste des photo-strukturierbaren Materials 18 zwischen der mindestens einen ersten Grabenwandfläche 34 und der mindestens einen zweiten Grabenwandfläche 36 können auch (nach einem vollständigen Ausführen des hier beschriebenen Verfahrens) verbleiben. Das mindestens eine photo-strukturierbare Material 18 kann jedoch auch (abhängig von seiner Abtragbarkeit während des chemischen oder physikalischen Abtragverfahrens) beim chemischen oder physikalischen Abtragverfahren mitentfernt werden. In diesem Fall kann eine Abformung der Materialreste der photo-strukturierbaren Schicht 18a zwischen der mindestens einen ersten Grabenwandfläche 34 und der mindestens einen zweiten Grabenwandfläche 36 ausgeformt werden.

Es wird darauf hingewiesen, dass bei einer Ausführung der hier beschriebenen Verfahrensschritte auf Waferebene das Vereinzeln der Halbleiterbauteile 12 vorzugsweise vor dem Entfernen des Opfermaterials 16 ausgeführt wird, da in diesem Fall das Opfermaterial 16 noch für einen zusätzlichen Schutz des mindestens einen Halbleiterbauteils 12 während des Vereinzelns sorgt.

Fig. 1h zeigt eine (durch ein vollständiges Ausführen des hier beschriebenen Verfahrens) hergestellte Halbleitervorrichtung nach einem optionalen Verfahrensschritt, in welchem mindestens ein sensitives Material 38 zum Nachweisen mindestens eines Stoffes auf der mindestens einen freigelegten Teiloberfläche 14 abgeschieden wird. (Das mittels der zuvor beschriebenen Verfahrensschritte verpackte mindestens eine Halbleiterbauteil 12 kann somit als mindestens ein Sensorbauteil zum Nachweisen des mindestens einen Stoffes vorteilhaft eingesetzt werden.) Es wird jedoch darauf hingewiesen, dass eine Nutzbarkeit des mittels der vorausgehend beschriebenen Verfahrensschritte verpackten mindestens einen Halbleiterbauteils 12 nicht auf einen Stoffnachweis limitiert ist.

Als Weiterbildung des hier beschriebenen Verfahrens können auch mindestens zwei Gräben 30 pro Halbleiterbauteil 12 gebildet werden. In diesem Fall können unterschiedliche sensitive Materialien in den mindestens zwei Gräben 30 pro Halbleiterbauteil 12 abgeschieden werden.

Zum Abscheiden des mindestens einen sensitiven Materials 38 kann z.B. ein Tropf-Verfahren oder ein Ink-Jet-Verfahren ausgeführt werden. Bei allen diesen Verfahren kann der mindestens eine Graben 30 als Beschichtungsmaske dienen. Außerdem kann bei allen diesen Verfahren durch Variation des mindestens einen sensitiven Materials 38 und/oder einer Geometrie des mindestens einen Grabens 30 (z.B. dessen Durchmesser) wahlweise eine (nahezu) homogene Schichtdicke des mindestens einen sensitiven Materials 38 (nach dessen Trocknen) oder eine Ausbildung eines (evtl. gewünschten) Meniskus an dem mindestens einen sensitiven Material 38 erreicht werden. Der mindestens eine Graben 30 kann auch vollständig mit dem jeweiligen sensitiven Material 38 gefüllt werden. In diesem Fall kann der mindestens eine Graben 30 vollständig mit einer eine geringere Konzentration des jeweiligen sensitiven Materials 38 aufweisenden Lösung gefüllt werden, so dass nach einem Trocknen der Lösung das jeweilige sensitive Material 38 auch auf den Grabenwandflächen 34 und 36 liegt.

Außerdem kann das oben beschriebene Verfahren auch ausgeführt werden, nachdem das mindestens eine sensitive Material 38 auf der mindestens einen Teiloberfläche 14 abgeschieden ist.

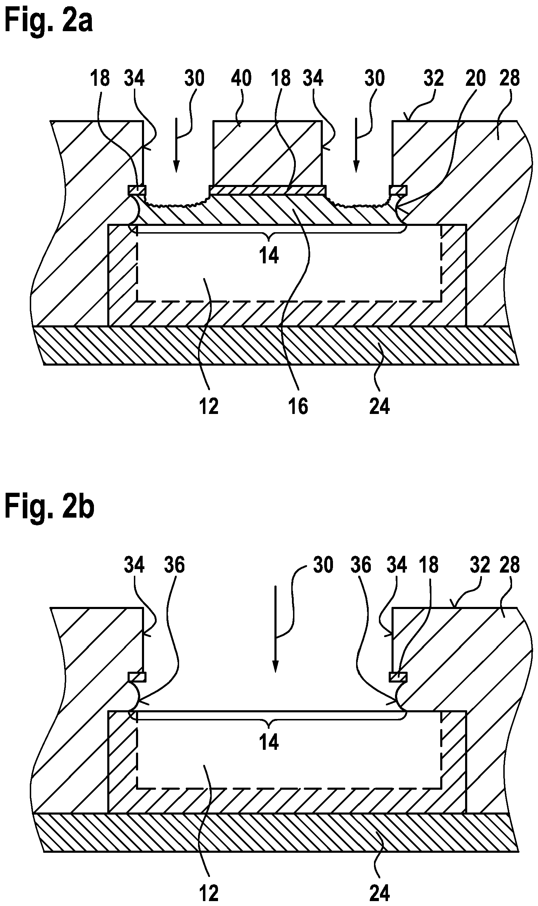

Fig. 2a und 2b zeigen schematische Querschnitte zum Erläutern einer zweiten Ausführungsform des Verfahrens zum Verpacken mindestens eines Halbleiterbauteils.

Bei der hier beschriebenen Ausführungsform wird, wie in Fig. 2a bildlich wiedergegeben ist, der mindestens eine Graben 30 zumindest durch das Verpackungsmaterial 28 mittels des Lichtstrahls mindestens in Form einer (vollständigen) Umrahmung eines Pfropfens 40 gebildet. Anschließend wird der Pfropfen 40 bei dem zumindest teilweisen Entfernen des zuvor freigelegten Opfermaterials 16 mittels des chemischen oder physikalischen Abtragverfahrens mitentfernt.

Wie anhand von Fig. 2b erkannt werden kann, eignet sich diese Ausführungsform des Verfahrens zum Realisieren von vergleichsweise großen Öffnungen/Kavernen (als den mindestens einen Graben 30), ohne dass dazu eine große Menge des Verpackungsmaterials 28 mittels des Lichtstrahls abgetragen werden muss. Es können für eine bessere Erreichbarkeit des Opfermaterials 16 beim Abtragverfahren und für eine bessere Ablösung von dem Opfermaterial 16 zusätzlich zur vollständigen Umrahmung auch weitere Gräben 30, z.B. in Form eines Rasters oder punktueller Öffnungen, innerhalb eines Pfropfens 40 gebildet werden.

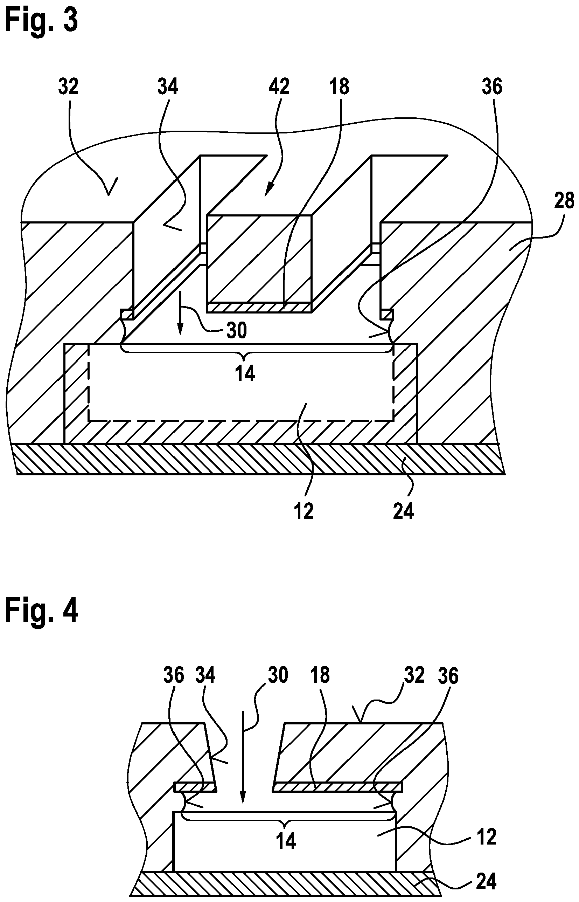

Fig. 3 zeigt einen schematischen Querschnitt zum Erläutern einer dritten Ausführungsform des Verfahrens zum Verpacken mindestens eines Halbleiterbauteils.

Bei der in Fig. 3 dargestellten Ausführungsform wird der mindestens eine Graben 30 zumindest durch das Verpackungsmaterial 28 mittels des Lichtstrahls in Form einer Teilumrahmung einer späteren Teilabschirmung 42 der mindestens einen Teiloberfläche 14 (aus dem Verpackungsmaterial 28) gebildet. Anschließend wird das zwischen der Teilabschirmung 32 und der zugeordneten Teiloberfläche 14 liegende Opfermaterial 16 zumindest teilweise mittels des chemischen oder physikalischen Abtragverfahrens entfernt. Die nach dem chemischen oder physikalischen Abtragverfahren verbleibende Teilabschirmung kann während eines weiteren Bearbeitens oder eines Betriebs der Halbleitervorrichtung einen mechanischen Schutz gegenüber einem Eindringen von Partikeln oder gegenüber einer Krafteinwirkung für die damit teilweise abgedeckte Teiloberfläche 14 bieten. Gleichzeitig bleibt die jeweilige Teiloberfläche 14 über den ihre Teilabschirmung 42 umgebenden Graben 30 mit einer Umgebung des Halbleiterbauteils 12 verbunden, so dass mindestens eine Umgebungsinformation, wie beispielsweise ein chemischer Bestandteil der Umgebung, eine Temperatur der Umgebung, eine Luftfeuchtigkeit der Umgebung und/oder ein in der Umgebung herrschender Druck mittels einer an der Teiloberfläche 14 ausgebildeten Sensorik ermittelbar ist.

Mittels aller oben beschriebenen Verfahren kann mindestens ein Sensorbauteil als das mindestens eine Halbleiterbauteil 12 mit dem Verpackungsmaterial 28 verpackt werden, wobei mindestens ein Medienzugang und/oder mindestens ein Messgang als der mindestens eine Graben 30 gebildet werden.

Fig. 4 zeigt eine schematische Darstellung einer ersten Ausführungsform der Halbleitervorrichtung.

Die in Fig. 4 schematisch dargestellte Halbleitervorrichtung umfasst ein Halbleiterbauteil 12, welches zumindest teilweise von einem optisch abtragbaren Verpackungsmaterial 28 umgeben ist, wobei mindestens eine Teiloberfläche 14 des Halbleiterbauteils 12 mittels mindestens eines zumindest durch das Verpackungsmaterial 28 verlaufenden Grabens 30 freigelegt ist. Die Halbleitervorrichtung der Fig. 4 ist mittels des vorausgehend beschriebenen Verfahrens zum Verpacken mindestens eines Halbleiterbauteils 12 in dem Verpackungsmaterial 28 verpackt/hergestellt. Dies ist vor allem daran erkennbar, dass der mindestens eine Graben 30 zwischen der mindestens einen ersten Grabenwandfläche 34 und der mindestens einen zweiten Grabenwandfläche 36 metallisierungs-frei ist. (Darunter ist zu verstehen, dass alle evtl. zwischen der mindestens einen ersten Grabenwandfläche 34 und der mindestens einen zweiten Grabenwandfläche 36 vorliegenden Innenflächen des mindestens einen Grabens 30 unabgedeckt/frei von einer Metallisierung sind.) Außerdem weist der mindestens eine Graben 30 jeweils mindestens eine an einer Außengrenzfläche 32 des Verpackungsmaterials 28 angrenzenden erste Grabenwandfläche 34 aus dem Verpackungsmaterial 28 mit Lichtabtragspuren und mindestens eine zumindest teilweise aus dem Verpackungsmaterial 28 gebildete zweite Grabenwandfläche 36 mit Füllstoffabtragspuren, Ätzresten und/oder Abformeffekten auf. Die mindestens eine zweite Grabenwandfläche 36 liegt im Vergleich mit der mindestens einen ersten Grabenwandfläche 34 des gleichen Grabens 30 näher an der zugeordneten Teiloberfläche 14. Insbesondere kann die mindestens eine zumindest teilweise aus dem Verpackungsmaterial gebildete zweite Grabenwandfläche 36 mit mindestens einer konvexen Wölbung und/oder mindestens einer konkaven Wölbung ausgebildet sein. Materialreste einer zuvorigen photo-strukturierbaren Schicht 18a können ebenfalls zwischen der mindestens einen ersten Grabenwandfläche 34 und der mindestens einen zweiten Grabenwandfläche 36 vorliegen. Auch eine Abformung der Materialreste der photo-strukturierbaren Schicht 18a kann zwischen der mindestens einen ersten Grabenwandfläche 34 und der mindestens einen zweiten Grabenwandfläche 36 ausgeformt sein.

Die Halbleitervorrichtung der Fig. 4 kann ein mit dem Verpackungsmaterial 28 verpacktes Sensorbauteil als das Halbleiterbauteil 12 umfassen und mit mindestens einem Medienzugang und/oder mindestens einem Messgang als dem mindestens einen Graben 30 ausgebildet sein. Die Halbleitervorrichtung der Fig. 4 kann jedoch auch für andere Verwendungszwecke eingesetzt werden.

Wie in Fig. 4 erkennbar ist, kann (nahezu) eine gesamte Seite des mindestens einen Halbleiterchips 12 durch den mindestens einen Graben 30 freigelegt sein. Der Halbleiterchip 12 hat an der jeweiligen Seite keinen mechanischen Kontakt zu dem Verpackungsmaterial 28. Der mindestens eine Graben 30 kann somit auch zur Stressentkopplung (insbesondere für einen Beschleunigungssensor) beitragen. (Es wird nochmals darauf hingewiesen, dass die Ausstattung der Halbleitervorrichtung mit der Leiterplatte 24 nicht notwendig ist.)

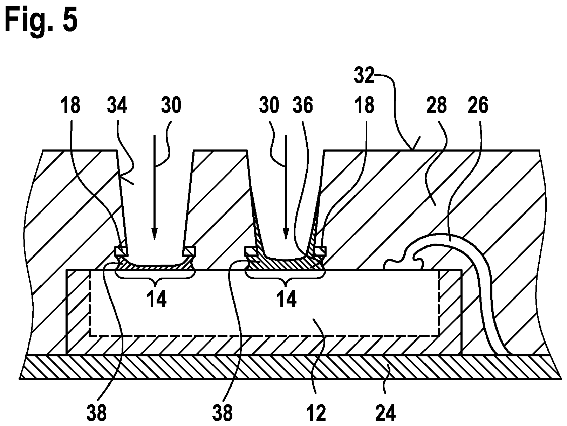

Fig. 5 zeigt eine schematische Darstellung einer zweiten Ausführungsform der Halbleitervorrichtung.

Die als chemischer Nachweissensor ausgebildete Halbleitervorrichtung der Fig. 5 weist mindestens ein sensitives Material 38 zum Nachweisen mindestens eines Stoffes auf, welches auf der mindestens einen freigelegten Teiloberfläche 14 abgeschieden ist. Speziell weist die Halbleitervorrichtung mindestens zwei Gräben 30 mit unterschiedlichen sensitiven Materialien 38 auf.

## Patentansprüche

1. Verfahren zum Verpacken mindestens eines Halbleiterbauteils (12) mit den Schritten:
Abdecken mindestens einer Teiloberfläche (14) des mindestens einen Halbleiterbauteils (12) mit zumindest einem chemisch oder physikalisch auflösbaren Opfermaterial (16);
Zumindest teilweises Umgeben des mindestens einen Halbleiterbauteils (12) mit einem optisch abtragbaren Verpackungsmaterial (28), wobei auch zumindest das Opfermaterial (16) auf der mindestens einen Teiloberfläche (14) des mindestens einen Halbleiterbauteils (12) mit dem Verpackungsmaterial (28) umgeben wird;
Freilegen des Opfermaterials (16) auf der mindestens einen Teiloberfläche (14) des mindestens einen Halbleiterbauteils (12) zumindest teilweise durch Bilden mindestens eines Grabens (30) zumindest durch das Verpackungsmaterial (28) mittels eines Lichtstrahls, wobei zumindest das Verpackungsmaterial (28) bereichsweise optisch abgetragen wird; und
Freilegen der mindestens einen Teiloberfläche (14) des mindestens einen Halbleiterbauteils (12) zumindest teilweise durch ein zumindest teilweises Entfernen des zuvor freigelegten Opfermaterials (16) mittels eines chemischen oder physikalischen Abtragverfahrens, gegen welches das Verpackungsmaterial (28) im Vergleich mit dem Opfermaterial (16) eine höhere Resistenz aufweist;
wobei zum Abdecken der mindestens einen Teiloberfläche (14) mit zumindest dem chemisch oder physikalisch auflösbaren Opfermaterial (16) eine Opfermaterialschicht (16a) aus dem Opfermaterial (16) abgeschieden und eine photo-strukturierbare Schicht (18a) aus einem photo-strukturierbaren Material (18) auf der Opfermaterialschicht (16a) abgeschieden und strukturiert wird, wobei die von der photo-strukturierbaren Schicht (18a) abgedeckte Opfermaterialschicht (16a) mitstrukturiert wird und die Strukturierung der Opfermaterialschicht (16a) und der photo-strukturierbaren Schicht (18a) so erfolgt, dass nur die mindestens eine Teiloberfläche (14) abdeckende Restbereiche (16b und 18b) aus dem Opfermaterial (16) und dem photo-strukturierbaren Material (18) verbleiben
wobei die strukturierte Opfermaterialschicht (16a) und die photo-strukturierte Schicht (18b) auf der mindestens einen Teiloberfläche (14) des mindestens einen Halbleiterbauteils (12) mit dem Verpackungsmaterial (28) umgeben wird; und
beim Bilden des mindestens einen Grabens (30) mittels des Lichtstrahls auch der mindestens eine Restbereich (18b) aus dem photo-strukturierbaren Material (18) zumindest teilweise entfernt wird.

2. Verfahren nach Anspruch 1, wobei der mindestens eine Graben (30) jeweils mittels des Lichtstrahls mit mindestens einer an einer Außengrenzfläche (32) des Verpackungsmaterials (28) angrenzenden ersten Grabenwandfläche (34) aus dem Verpackungsmaterial (28) mit Lichtabtragspuren und mittels des chemischen oder physikalischen Abtragverfahrens mit mindestens einer zweiten Grabenwandfläche (36), welche im Vergleich mit der mindestens einen ersten Grabenwandfläche (34) des gleichen Grabens (30) näher an der zugeordneten Teiloberfläche (14) liegt, zumindest teilweise aus dem Verpackungsmaterial (28) besteht und mit Füllstoffabtragspuren, Ätzresten und/oder Abformeffekten gebildet ist, ausgebildet wird, und wobei der jeweilige mindestens eine Graben (30) zwischen der mindestens einen ersten Grabenwandfläche (34) und der mindestens einen zweiten Grabenwandfläche (36) metallisierungs-frei und mit Materialresten des photo-strukturierbaren Materials (18) zwischen der mindestens einen ersten Grabenwandfläche (34) und der mindestens einen zweiten Grabenwandfläche (36) ausgebildet wird.

3. Verfahren nach Anspruch 2, wobei zum Abdecken der mindestens einen Teiloberfläche (14) die Opfermaterialschicht (16a) aus dem Opfermaterial (16) auf dem mindesten einen Halbleiterbauteil (12) so strukturiert wird, dass mindestens eine konkave Außenfläche (20) und/oder mindestens eine konvexe Außenfläche des die mindestens eine Teiloberfläche (14) abdeckenden Opfermaterials (16) gebildet wird, so dass die mindestens eine zumindest teilweise aus dem Verpackungsmaterial (28) gebildete zweite Grabenwandfläche (36) mit einer konvexen Wölbung und/oder einer konkaven Wölbung ausgebildet wird.

4. Verfahren nach einem der vorhergehenden Ansprüche, wobei mindestens ein Sensorbauteil als das mindestens eine Halbleiterbauteil (12) mit dem Verpackungsmaterial (28) verpackt wird, und wobei mindestens ein Medienzugang und/oder mindestens ein Messgang als der mindestens eine Graben (30) gebildet werden.

5. Verfahren nach Anspruch 4, wobei mindestens ein sensitives Material (38) zum Nachweisen mindestens eines Stoffes auf der mindestens einen freigelegten Teiloberfläche (14) abgeschieden wird.

6. Verfahren nach Anspruch 5, wobei mindestens zwei Gräben (30) pro Halbleiterbauteil (12) gebildet werden, und wobei unterschiedliche sensitive Materialien (38) in den mindestens zwei Gräben (30) pro Halbleiterbauteil (12) abgeschieden werden.

7. Verfahren nach einem der vorhergehenden Ansprüche, wobei der mindestens eine Graben (30) zumindest durch das Verpackungsmaterial (28) mittels des Lichtstrahls mindestens in Form einer Umrahmung eines Pfropfens (40) gebildet wird, und wobei der Pfropfen (40) beim Entfernen des zuvor freigelegten Opfermaterials (16) zumindest teilweise mittels des chemischen oder physikalischen Abtragverfahrens mitentfernt wird.

8. Verfahren nach einem der vorhergehenden Ansprüche, wobei der mindestens eine Graben (30) zumindest durch das Verpackungsmaterial (28) mittels des Lichtstrahls in Form einer Teilumrahmung einer späteren Teilabschirmung (42) der mindestens einen Teiloberfläche (14) gebildet wird, und wobei das zwischen der Teilabschirmung (42) und der jeweiligen Teiloberfläche (14) liegende Opfermaterial (16) zumindest teilweise mittels des chemischen oder physikalischen Abtragverfahrens entfernt wird.

9. Halbleitervorrichtung umfassend:
ein Halbleiterbauteil (12), welches teilweise von einem optisch abtragbaren Verpackungsmaterial (28) umgeben ist;
wobei mindestens eine Teiloberfläche (14) des Halbleiterbauteils (12) mittels mindestens eines zumindest durch das Verpackungsmaterial (28) verlaufenden Grabens (30) freigelegt ist;
wobei der mindestens eine Graben (30) jeweils mindestens eine an einer Außengrenzfläche (32) des Verpackungsmaterials (28) angrenzende erste Grabenwandfläche (34) aus dem Verpackungsmaterial (28) mit Lichtabtragspuren und mindestens eine zweite Grabenwandfläche (36), welche im Vergleich mit der mindestens einen ersten Grabenwandfläche (34) des gleichen Grabens (30) näher an der zugeordneten Teiloberfläche (14) liegt, teilweise aus dem Verpackungsmaterial (28) besteht und mit Füllstoffabtragspuren, Ätzresten und/oder Abformeffekten gebildet ist, aufweist, und der jeweilige mindestens eine Graben (30) zwischen der mindestens einen ersten Grabenwandfläche (34) und der mindestens einen zweiten Grabenwandfläche (36) metallisierungs-frei ist und Materialreste eines photo-strukturierbaren Materials (18) zwischen der mindestens einen ersten Grabenwandfläche (34) und der mindestens einen zweiten Grabenwandfläche (36) vorliegen.

10. Halbleitervorrichtung nach Anspruch 9, wobei die mindestens eine teilweise aus dem Verpackungsmaterial (28) gebildete zweite Grabenwandfläche (36) mit einer konvexen Wölbung und/oder einer konkaven Wölbung ausgebildet ist.

11. Halbleitervorrichtung nach Anspruch 9 oder 10, wobei die Halbleitervorrichtung ein mit dem Verpackungsmaterial (28) verpacktes Sensorbauteil als das Halbleiterbauteil umfasst, und mit mindestens einem Medienzugang und/oder mindestens einem Messgang als dem mindestens einen Graben (30) ausgebildet ist.

12. Halbleitervorrichtung nach Anspruch 11, wobei mindestens ein sensitives Material (38) zum Nachweisen mindestens eines Stoffes auf der mindestens einen freigelegten Teiloberfläche (14) abgeschieden ist.

13. Halbleitervorrichtung nach Anspruch 12, wobei die Halbleitervorrichtung mindestens zwei Gräben (30) mit unterschiedlichen sensitiven Materialien (38) aufweist.

## Claims

1. Method for packaging at least one semiconductor component (12) comprising the following steps:
covering at least one partial surface (14) of the at least one semiconductor component (12) with at least one chemically or physically dissoluble sacrificial material (16);
at least partially surrounding the at least one semiconductor component (12) with an optically removable packaging material (28), wherein at least the sacrificial material (16) on the at least one partial surface (14) of the at least one semiconductor component (12) is also surrounded with the packaging material (28);
uncovering the sacrificial material (16) on the at least one partial surface (14) of the at least one semiconductor component (12) at least partly by forming at least one trench (30) at least through the packaging material (28) by means of a light beam, wherein at least the packaging material (28) is optically removed regionally; and
uncovering the at least one partial surface (14) of the at least one semiconductor component (12) at least partly by at least partly removing the previously uncovered sacrificial material (16) by means of the chemical or physical removal method to which the packaging material (28) has a higher resistance in comparison with the sacrificial material (16);
wherein for covering the at least one partial surface (14) with at least the chemically or physically dissoluble sacrificial material (16), a sacrificial material layer (16a) composed of the sacrificial material (16) is deposited and a photopatternable layer (18a) composed of a photopatternable material (18) is deposited on the sacrificial material layer (16a) and patterned, wherein the sacrificial material layer (16a) covered by the photopatternable layer (18a) is concomitantly patterned and the sacrificial material layer (16a) and the photopatternable layer (18a) are patterned such that there remain only residual regions (16b and 18b) composed of the sacrificial material (16) and the photopatternable material (18) which covers the at least one partial surface (14),
wherein the patterned sacrificial material layer (16a) and the photopatterned layer (18b) on the at least one partial surface (14) of the at least one semiconductor component (12) are surrounded with the packaging material (28); and
during the process of forming the at least one trench (30) by means of the light beam, the at least one residual region (18b) composed of the photopatternable material (18) is at least partly removed as well.

2. Method according to Claim 1, wherein the at least one trench (30) is embodied in each case by means of the light beam with at least one first trench wall surface (34) which adjoins an outer interface (32) of the packaging material (28) and which is composed of the packaging material (28) with light removal traces and by means of the chemical or physical removal method with at least one second trench wall surface (36) which is situated closer to the assigned partial surface (14) in comparison with the at least one first trench wall surface (34) of the same trench (30), at least partly consists of the packaging material (28) and is formed with filler removal traces, etching residues and/or moulding effects, and wherein the respective at least one trench (30) is embodied as free of metallization between the at least one first trench wall surface (34) and the at least one second trench wall surface (36) and with material residues of the photopatternable material (18) between the at least one first trench wall surface (34) and the at least one second trench wall surface (36).

3. Method according to Claim 2, wherein for covering the at least one partial surface (14), the sacrificial material layer (16a) composed of the sacrificial material (16) on the at least one semiconductor component (12) is structured such that at least one concave outer surface (20) and/or at least one convex outer surface of the sacrificial material (16) covering at least one partial surface (14) are/is formed, such that the at least one second trench wall surface (36) formed at least partly from the packaging material (28) is embodied with a convex curvature and/or a concave curvature.

4. Method according to any of the preceding claims, wherein at least one sensor component as the at least one semiconductor component (12) is packaged with the packaging material (28), and wherein at least one media access and/or at least one measurement passage are/is formed as the at least one trench (30).

5. Method according to Claim 4, wherein at least one sensitive material (38) for detecting at least one substance is deposited on the at least one uncovered partial surface (14).

6. Method according to Claim 5, wherein at least two trenches (30) are formed per semiconductor component (12), and wherein different sensitive materials (38) are deposited in the at least two trenches (30) per semiconductor component (12).

7. Method according to any of the preceding claims, wherein the at least one trench (30) is formed at least through the packaging material (28) by means of the light beam at least in the form of a border around a plug (40), and wherein, during the process of removing the previously uncovered sacrificial material (16), the plug (40) is concomitantly removed at least partially by means of the chemical or physical removal method.

8. Method according to any of the preceding claims, wherein the at least one trench (30) is formed at least through the packaging material (28) by means of the light beam in the form of a partial border around a later partial shield (42) of the at least one partial surface (14), and wherein sacrificial material (16) situated between the partial shield (42) and the respective partial surface (14) is removed at least partly by means of the chemical or physical removal method.

9. Semiconductor device comprising:
a semiconductor component (12) partly surrounded by an optically removable packaging material (28);
wherein at least one partial surface (14) of the semiconductor component (12) is uncovered by means of at least one trench (30) extending at least through the packaging material (28);
wherein the at least one trench (30) has in each case at least one first trench wall surface (34) which adjoins an outer interface (32) of the packaging material (28) and which is composed of the packaging material (28) with light removal traces, and at least one second trench wall surface (36) which is situated closer to the assigned partial surface (14) in comparison with the at least one first trench wall surface (34) of the same trench (30), partly consists of the packaging material (28) and is formed with filler removal traces, etching residues and/or moulding effects, and the respective at least one trench (30) is free of metallization between the at least one first trench wall surface (34) and the at least one second trench wall surface (36) and there are material residues of a photopatternable material (18) between the at least one first trench wall surface (34) and the at least one second trench wall surface (36).

10. Semiconductor device according to Claim 9, wherein the at least one second trench wall surface (36) formed partly from the packaging material (28) is embodied with a convex curvature and/or a concave curvature.

11. Semiconductor device according to Claim 9 or 10, wherein the semiconductor device comprises a sensor component packaged with the packaging material (28) as the semiconductor component, and is embodied with at least one media access and/or at least one measurement passage as the at least one trench (30).

12. Semiconductor device according to Claim 11, wherein at least one sensitive material (38) for detecting at least one substance is deposited on the at least one uncovered partial surface (14).

13. Semiconductor device according to Claim 12, wherein the semiconductor device comprises at least two trenches (30) having different sensitive materials (38) .

## Revendications

1. Procédé de mise sous boîtier d'au moins un composant semi-conducteur (12), comprenant les étapes consistant à :
recouvrir au moins une surface partielle (14) de l'au moins un composant semi-conducteur (12) avec au moins un matériau sacrificiel (16) pouvant être dissous de manière chimique ou physique ;
enrober au moins partiellement ledit au moins un composant semi-conducteur (12) avec un matériau de mise sous boîtier (28) pouvant être ablaté de manière optique, au moins le matériau sacrificiel (16) étant également enrobé avec le matériau de mise sous boîtier (28) sur ladite au moins une surface partielle (14) de l'au moins un composant semi-conducteur (12) ;
exposer le matériau sacrificiel (16) sur ladite au moins une surface partielle (14) de l'au moins un composant semi-conducteur (12) au moins en partie par la formation d'au moins une tranchée (30) au moins à travers le matériau de mise en boîtier (28) au moyen d'un faisceau lumineux, au moins le matériau de mise en boîtier (28) étant ablaté optiquement par endroits ; et
exposer ladite au moins une surface partielle (14) de l'au moins un composant semi-conducteur (12) au moins en partie par une ablation au moins partielle du matériau sacrificiel (16) précédemment exposé au moyen d'un procédé d'ablation chimique ou physique auquel le matériau de mise en boîtier (28) présente une résistance supérieure en comparaison avec le matériau sacrificiel (16) ;
dans lequel
pour recouvrir ladite au moins une surface partielle (14) avec au moins le matériau sacrificiel (16) pouvant être dissous de manière chimique ou physique, une couche de matériau sacrificiel (16a) composée du matériau sacrificiel (16) est déposée et une couche photostructurable (18a) composée d'un matériau photostructurable (18) est déposée sur la couche de matériau sacrificiel (16a) et structurée, dans lequel la couche de matériau sacrificiel (16a) recouverte par la couche photostructurable (18a) est structurée en même temps et la structuration de la couche de matériau sacrificiel (16a) et de la couche photostructurable (18a) est effectuée de telle sorte que seules des zones résiduelles (16b et 18b) recouvrant ladite au moins une surface partielle (14) restent du matériau sacrificiel (16) et du matériau photostructurable (18),
dans lequel la couche de matériau sacrificiel structurée (16a) et la couche photostructurée (18b) sur ladite au moins une surface partielle (14) de l'au moins un composant semi-conducteur (12) est enrobée avec le matériau de mise en boîtier (28) ; et
lors de la formation de ladite au moins une tranchée (30) au moyen du faisceau lumineux, ladite au moins une zone résiduelle (18b) est également retirée au moins en partie du matériau photostructurable (18).

2. Procédé selon la revendication 1, dans lequel ladite au moins une tranchée (30) est réalisée respectivement au moyen du faisceau lumineux avec au moins une première surface de paroi de tranchée (34), composée du matériau de mise en boîtier (28), adjacente à une surface de limite extérieure (32) du matériau de mise en boîtier (28), avec des traces de photoablation, et au moyen du procédé d'ablation chimique ou physique avec au moins une deuxième surface de paroi de tranchée (36), qui se trouve plus près de la surface partielle (14) associée en comparaison avec ladite au moins une première surface de paroi de tranchée (34) de la même tranchée (30), se compose au moins en partie du matériau de mise en boîtier (28), et est formée avec des traces d'ablation de matière de charge, de résidus de gravure et/ou d'effets de moulage, et dans lequel ladite au moins une tranchée (30) respective est réalisée entre ladite au moins une première surface de paroi de tranchée (34) et ladite au moins une deuxième surface de paroi de tranchée (36) sans métallisation et avec des résidus de matériau du matériau photostructurable (18) entre ladite au moins une première surface de paroi de tranchée (34) et ladite au moins une deuxième surface de paroi de tranchée (36).

3. Procédé selon la revendication 2, dans lequel, pour recouvrir ladite au moins une surface partielle (14), la couche de matériau sacrificiel (16a) composée du matériau sacrificiel (16) est structurée sur ledit au moins un composant semi-conducteur (12) de telle sorte qu'au moins une surface extérieure concave (20) et/ou au moins une surface extérieure convexe du matériau sacrificiel (16) recouvrant ladite au moins une surface partielle (14) sont formées, de sorte que ladite au moins une deuxième surface de paroi de tranchée (36) formée au moins en partie à partir du matériau de mise en boîtier (28) est réalisée avec une courbure convexe et/ou une courbure concave.

4. Procédé selon l'une quelconque des revendications précédentes, dans lequel au moins un composant de capteur comme ledit au moins un composant semi-conducteur (12) est mis en boîtier avec le matériau de mise en boîtier (28), et dans lequel au moins un accès aux médias et/ou au moins un passage de mesure sont formés comme ladite au moins une tranchée (30).

5. Procédé selon la revendication 4, dans lequel au moins un matériau sensible (38) pour détecter au moins une substance est déposé sur ladite au moins une surface partielle (14) exposée.

6. Procédé selon la revendication 5, dans lequel au moins deux tranchées (30) sont formées pour chaque composant semi-conducteur (12), et des matériaux (38) de sensibilité différente sont déposés dans les au moins deux tranchées (30) pour chaque composant semi-conducteur (12).

7. Procédé selon l'une quelconque des revendications précédentes, dans lequel ladite au moins une tranchée (30) est formée au moins par le matériau de mise en boîtier (28) au moyen du faisceau lumineux au moins sous la forme d'une bordure d'un plot (40), et dans lequel le plot (40) est retiré en même temps lors du retrait du matériau sacrificiel (16) préalablement exposé au moins en partie au moyen du procédé d'ablation chimique ou physique.

8. Procédé selon l'une quelconque des revendications précédentes, dans lequel ladite au moins une tranchée (30) est formée au moins par le matériau de mise en boîtier (28) au moyen du faisceau lumineux sous la forme d'une bordure partielle d'un blindage partiel ultérieur (42) de ladite au moins une surface partielle (14), et dans lequel le matériau sacrificiel (16) situé entre le blindage partiel (42) et la surface partielle (14) respective est retiré au moins en partie au moyen du procédé d'ablation chimique ou physique.

9. Dispositif semi-conducteur, comprenant :
un composant semi-conducteur (12), qui est entouré en partie d'un matériau de mise en boîtier (28) pouvant être ablaté de manière optique ;
dans lequel au moins une surface partielle (14) du composant semi-conducteur (12) est exposée au moyen d'au moins une tranchée (30) s'étendant au moins à travers le matériau de mise en boîtier (28) ;
dans lequel
ladite au moins une tranchée (30) présente respectivement au moins une surface de paroi de tranchée (34) adjacente à une surface de limite extérieure (32) du matériau de mise en boîtier (28) composée du matériau de mise en boîtier (28) avec des traces de photoablation et au moins une deuxième surface de paroi de tranchée (36), qui se trouve plus près de la surface partielle (14) associée en comparaison avec ladite au moins une première surface de paroi de tranchée (34) de la même tranchée (30), est composée en partie du matériau de mise en boîtier (28), et est formée avec des traces d'ablation de matière de charge, de résidus de gravure et/ou d'effets de moulage, et ladite au moins une tranchée (30) respective est exempte de métallisation entre ladite au moins une première surface de paroi de tranchée (34) et ladite au moins une deuxième surface de paroi de tranchée (36) et il existe des résidus de matériau d'un matériau photostructurable (18) entre ladite au moins une première surface de paroi de tranchée (34) et ladite au moins une deuxième surface de paroi de tranchée (36).

10. Dispositif semi-conducteur selon la revendication 9, dans lequel ladite au moins une deuxième surface de paroi de tranchée (36) formée partiellement à partir du matériau de mise en boîtier (28) est réalisée avec une courbure convexe et/ou une courbure concave.

11. Dispositif semi-conducteur selon la revendication 9 ou 10, dans lequel le dispositif semi-conducteur comprend un composant de détection comme composant semi-conducteur mis en boîtier par le matériau de mise en boîtier (28), et est réalisé avec au moins un accès aux médias et/ou au moins un chemin de mesure comme ladite au moins une tranchée (30).

12. Dispositif semi-conducteur selon la revendication 11, dans lequel au moins un matériau sensible (38) pour détecter au moins une substance est déposé sur ladite au moins une surface partielle exposée (14).

13. Dispositif semi-conducteur selon la revendication 12, dans lequel le dispositif semi-conducteur présente au moins deux tranchées (30) avec des matériaux (38) de différentes sensibilités.
